# EUROPEAN PATENT SPECIFICATION

(11) **EP 3 290 454 B1**
(45) Date of publication and mention of the grant of the patent: **06.05.2020**
(21) Application number: 16786383.6
(22) Date of filing: 20.04.2016
(51) Int. Cl.: C08G 59/40, B32B 15/08, C08J 5/24, C08K 5/315, C08L 63/00, C08L 101/00, H05K 1/03

(54) **RESIN COMPOSITION, PREPREG, METAL-FOIL-CLAD LAMINATE, RESIN SHEET, AND PRINTED WIRING BOARD**
HARZZUSAMMENSETZUNG, PREPREG, METALLFOLIENKASCHIERTES LAMINAT, HARZFOLIE UND LEITERPLATTE
COMPOSITION DE RÉSINE, PRÉIMPRÉGNÉ, STRATIFIÉ REVÊTU D'UNE FEUILLE MÉTALLIQUE, FEUILLE DE RÉSINE, ET CARTE DE CIRCUIT IMPRIMÉ

(30) Priority: 28.04.2015 JP 2015091041
(43) Date of publication of application: 07.03.2018
(73) Proprietor: Mitsubishi Gas Chemical Company, Inc., Tokyo 100-8324 (JP)
(72) Inventor: KOBAYASHI, Takashi, Tokyo 125-8601 (JP); TAKANO, Kentaro, Tokyo 125-8601 (JP)
(74) Representative: Hoffmann Eitle
(86) International application number: PCT/JP2016/062569
(87) International publication number: WO 2016/175106

(56) References cited:
- EP-A1- 2 733 177
- EP-A1- 2 774 938
- EP-A1- 2 829 568
- WO-A1-2013/065694
- WO-A1-2014/203866
- JP-A- H05 271 442
- JP-A- H05 271 442
- JP-A- 2006 229 038
- JP-A- 2006 229 038
- JP-A- 2007 227 567
- JP-A- 2007 284 467
- JP-A- 2014 108 531
- JP-A- 2014 205 755
- US-A1- 2015 024 215

## Description

### Technical Field

The present invention relates to a resin composition, a prepreg, a metal foil-clad laminate, a resin sheet, and a printed wiring board.

### Background Art

In recent years, higher integration and miniaturization of semiconductors widely used in electronic equipment, communication instruments, personal computers, and the like have accelerated increasingly. With this, various characteristics required of laminates for semiconductor packages used in printed wiring boards have become increasingly strict. Examples of the required characteristics include characteristics such as low water absorbency, moisture absorption heat resistance, flame retardancy, a low dielectric constant, a low dielectric loss tangent, a low thermal expansion coefficient, heat resistance, chemical resistance, and high plating peel strength. But, these required characteristics have not always been satisfied so far.

Conventionally, as resins for printed wiring boards having excellent heat resistance and electrical characteristics, cyanate compounds are known, and among them, resin compositions using cyanate compounds in combination with epoxy resins and the like have been widely used for materials for highly functional printed wiring boards such as for semiconductor plastic packages, and the like in recent years. In addition, due to smaller size and higher density of multilayer printed wiring boards, in the multilayer printed wiring boards, the buildup layers are multilayered, and miniaturization and higher density of the wiring are required. Further resin compositions related to those of the present invention and uses thereof in printed wiring boards are described in Patent Literatures 4 to 10.

### Citation List

### Patent Literature

Patent Literature 1: International Publication No. WO 2013/065694
Patent Literature 2: International Publication No. WO 2014/203866
Patent Literature 3: Japanese Patent No. 5413522
Patent Literature 4: US Patent Application No. US 2015/024215 A1
Patent Literature 5: Japanese Patent Application Publication No. JP 2014 108531 APatent Literature 6: European Patent Application No. EP 2 733 177 A1
Patent Literature 7: European Patent Application No. EP 2 829 568 A1
Patent Literature 8: Japanese Patent Application Publication No. JP 2007 284467 A
Patent Literature 9: Japanese Patent Application Publication No. JP 2006 229038 A
Patent Literature 10: Japanese Patent Application Publication No. JP H05 271442 A

### Summary of Invention

### Technical Problem

Here, resin compositions comprising a cyanate compound and an epoxy resin that have excellent characteristics such as adhesiveness, low water absorbency, moisture absorption heat resistance, and insulation reliability are proposed (for example, see Patent Literatures 1 and 2), but plating peel strength is still insufficient, and therefore a further improvement in plating peel strength is required.

In addition, as a method for improving copper foil peel strength and plating peel strength, a method of surface-treating a filler is proposed (see Patent Literature 3), but plating peel strength is still insufficient, and therefore a further improvement in plating peel strength is required.

Accordingly, the present invention has been made in view of the above problem of the conventional art, and an object of the present invention is to provide a resin composition from which a cured product having excellent heat resistance and also excellent plating adhesiveness is obtained and which can realize a printed wiring board having excellent plating peel strength.

### Solution to Problem

The present inventors have diligently studied the above problem and, as a result, found that by using a resin composition containing a cyanate compound (A) and an epoxy resin (B) having a predetermined structure, a cured product having excellent heat resistance and also excellent plating adhesiveness is obtained, and a printed wiring board having high plating peel strength is obtained, arriving at the present invention. Specifically, the present invention is as follows.
[1] A resin composition comprising a cyanate compound (A), wherein the cyanate compound (A) comprises a naphthol aralkyl-based cyanate compound; and an epoxy resin (B) represented by the following general formula (1): 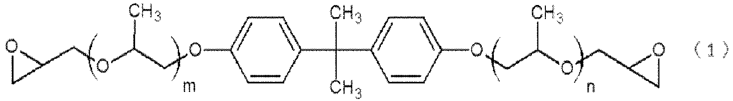 wherein m and n each independently represent an integer of 1 or more; and the epoxy resin (B) represented by general formula (1) may be a mixture of compounds in which m and n each independently represent a different integer.
[2] The resin composition according to [1], wherein a content of the epoxy resin (B) represented by the general formula (1) is 1 to 90 parts by mass based on a total amount (100 parts by mass) of resin solids in the resin composition.
[3] The resin composition according to [1] or [2], further comprising a filler (C).
[4] The resin composition according to claim 1, wherein the filler (C) comprises silica.
[5] The resin composition according to any of [1] to [4], further comprising one or two or more selected from the group consisting of an epoxy resin other than the epoxy resin (B) represented by the general formula (1), a maleimide compound, a phenolic resin, an oxetane resin, a benzoxazine compound, and a compound having a polymerizable unsaturated group.
[6] The resin composition according to [3], [4] or [5], wherein a content of the filler (C) is 50 to 1600 parts by mass based on a total amount (100 parts by mass) of the resin solids in the resin composition.
[7] A prepreg comprising a base material; and the resin composition according to any of [1] to [6] with which the base material is impregnated or coated.
[8] A metal foil-clad laminate comprising one of the prepreg according to [7] or two or more of the prepregs according to [7] laminated; and metal foil laminate-molded on one surface or both surfaces of the prepreg.
[9] A resin sheet comprising a sheet base material; and the resin composition according to any of [1] to [6] with which one surface or both surfaces of the sheet base material is coated and which is dried.
[10] A printed wiring board comprising an insulating layer comprising the resin composition according to any of [1] to [6]; and a conductor layer formed on one surface or both surfaces of the insulating layer. Advantageous Effect of Invention

According to the resin composition according to the present invention, a cured product having excellent heat resistance and also excellent plating adhesiveness is obtained, and a high performance printed wiring board having excellent plating peel strength can be realized. Description of Embodiment

A mode for carrying out the present invention (hereinafter simply referred to as "this embodiment") will be described in detail below. This embodiment below is an illustration for describing the present invention and is not intended to limit the present invention to the embodiment below.

### <Resin Composition>

A resin composition in this embodiment comprises a cyanate compound (A), wherein the cyanate compound (A) comprises a naphthol aralkyl-based cyanate compound; and an epoxy resin (B) represented by the following general formula (1) (hereinafter also simply referred to as an "epoxy resin (B)"). 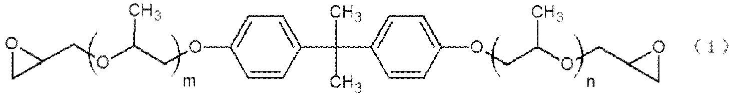 wherein m and n each independently represent an integer of 1 or more. The epoxy resin (B) represented by general formula (1) may be a mixture of compounds in which m and n each independently represent a different integer. According to the resin composition in this embodiment, a high performance printed wiring board having excellent plating peel strength can be realized. The factor of this is presumed as follows (however, the factor is not limited to this). When the resin composition in this embodiment mainly contains the epoxy resin (B) represented by general formula (1), excellent plating peel strength can be obtained due to the fact that the viscosity of the epoxy resin (B) is relatively low, and the size of space produced for an object such as a base material or a support is small when the resin composition is molded. In addition, by mainly containing the cyanate compound (A), a cured product having excellent heat resistance and also excellent plating adhesiveness can be obtained due to the fact that glass transition temperature is high.

### <Cyanate Compound (A)>

The cyanate compound (A) comprises a naphthol aralkyl-based cyanate compound. By containing the cyanate compound (A) in this embodiment, a resin composition that realizes a printed wiring board having excellent heat resistance can be obtained. For the factor of this, it is presumed that by containing the cyanate compound (A), a printed wiring board having better heat resistance is obtained due to the fact that the glass transition temperature of the entire resin composition increases (however, the factor is not limited to this).

Examples of the cyanate compound (A) of the present disclosure include a compound represented by the following general formula (2) while the present invention requires the cyanate compound (A) to comprise a naphthol aralkyl-based cyanate compound. One cyanate compound (A) can be used alone, or two or more cyanate compounds (A) can be used in combination. 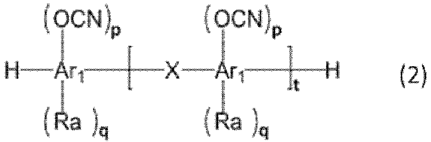 wherein Ar₁ each independently represents a phenylene group that may have a substituent, a naphthylene group that may have a substituent, or a biphenylene group that may have a substituent; Ra is each independently selected from any one of a hydrogen atom, an alkyl group having 1 to 6 carbon atoms that may have a substituent, an aryl group having 6 to 12 carbon atoms that may have a substituent, an alkoxyl group having 1 to 4 carbon atoms that may have a substituent, an aralkyl group that may have a substituent in which an alkyl group having 1 to 6 carbon atoms and an aryl group having 6 to 12 carbon atoms are bonded to each other, or an alkylaryl group that may have a substituent in which an alkyl group having 1 to 6 carbon atoms and an aryl group having 6 to 12 carbon atoms are bonded to each other; p represents the number of cyanato groups bonded to Ar₁ and is an integer of 1 to 3; q represents the number of Ra bonded to Ar₁ and is 4 - p when Ar₁ is a phenylene group, 6 - p when Ar₁ is a naphthylene group, and 8 - p when Ar₁ is a biphenylene group; t represents the average number of repetitions and is an integer of 0 to 50, and the cyanate compound may be a mixture of compounds having different t; and X is each independently selected from any one of a single bond, a divalent organic group having 1 to 50 carbon atoms (a hydrogen atom may be replaced by a heteroatom), a divalent organic group having 1 to 10 nitrogen atoms (-N-R-N-or the like), a carbonyl group (-CO-), a carboxy group (-C(=O)O-), a carbonyl dioxide group (-OC(=O)O-), a sulfonyl group (-SO₂-), or a divalent sulfur atom or a divalent oxygen atom.

The alkyl group represented by Ra in general formula (2) may have either of a chain structure and a cyclic structure (cycloalkyl group or the like). In addition, a hydrogen atom in the alkyl group and the aryl group for Ra in general formula (2) may be replaced by a halogen atom such as fluorine or chlorine, an alkoxyl group such as a methoxy group or a phenoxy group, a cyano group, or the like.

Specific examples of the alkyl group for Ra in general formula (2) are not particularly limited and include a methyl group, an ethyl group, a propyl group, an isopropyl group, a n-butyl group, an isobutyl group, a tert-butyl group, a n-pentyl group, a 1-ethylpropyl group, a 2,2-dimethylpropyl group, a cyclopentyl group, a hexyl group, a cyclohexyl group, and a trifluoromethyl group.

Specific examples of the aryl group for Ra in general formula (2) are not particularly limited and include a phenyl group, a xylyl group, a mesityl group, a naphthyl group, a phenoxyphenyl group, an ethylphenyl group, an o-, m-, or p-fluorophenyl group, a dichlorophenyl group, a dicyanophenyl group, a trifluorophenyl group, a methoxyphenyl group, and an o-, m-, or p-tolyl group.

Specific examples of the alkoxyl group for Ra in general formula (2) are not particularly limited and include a methoxy group, an ethoxy group, a propoxy group, an isopropoxy group, a n-butoxy group, an isobutoxy group, and a tert-butoxy group.

Specific examples of the divalent organic group for X in general formula (2) are not particularly limited and include a methylene group, an ethylene group, a trimethylene group, a cyclopentylene group, a cyclohexylene group, a trimethylcyclohexylene group, a biphenylylmethylene group, a dimethylmethylene-phenylene-dimethylmethylene group, a fluorenediyl group, and a phthalidediyl group. A hydrogen atom in the divalent organic group represented by X may be replaced by a halogen atom such as fluorine or chlorine, an alkoxyl group such as a methoxy group or a phenoxy group, a cyano group, or the like.

Examples of the divalent organic group having 1 to 10 nitrogen atoms for X in general formula (2) are not particularly limited and include an imino group and a polyimide group.

In addition, examples of X in general formula (2) include a group having a structure represented by the following general formula (3) or the following general formula (4). 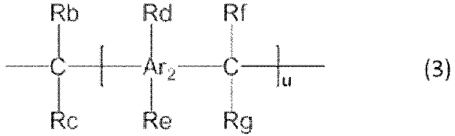 wherein Ar₂ is each independently selected from any one of a phenylene group, a naphthylene group, and a biphenylene group; Rb, Rc, Rf, and Rg are each independently selected from any one of a hydrogen atom, an alkyl group having 1 to 6 carbon atoms, an aryl group having 6 to 12 carbon atoms, a trifluoromethyl group, and an aryl group substituted by at least one phenolic hydroxy group; Rd and Re are each independently selected from any one of a hydrogen atom, an alkyl group having 1 to 6 carbon atoms, an aryl group having 6 to 12 carbon atoms, an alkoxyl group having 1 to 4 carbon atoms, and a hydroxy group; and u represents an integer of 0 to 5, and the cyanate compound may be a mixture of compounds having different u. 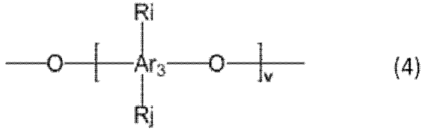 wherein Ar₃ is each independently selected from any one of a phenylene group, a naphthylene group, or a biphenylene group; Ri and Rj are each independently selected from any one of a hydrogen atom, an alkyl group having 1 to 6 carbon atoms, an aryl group having 6 to 12 carbon atoms, a benzyl group, an alkoxyl group having 1 to 4 carbon atoms, a hydroxy group, a trifluoromethyl group, and an aryl group substituted by at least one cyanato group; and v represents an integer of 0 to 5, and the cyanate compound may be a mixture of compounds having different v.

Further, examples of X in general formula (2) include divalent groups represented by the following formulas: 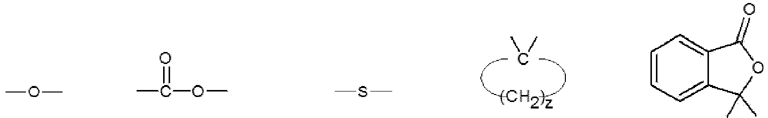 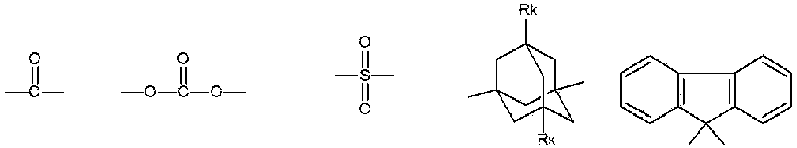 wherein z represents an integer of 4 to 7; and Rk each independently represents a hydrogen atom or an alkyl group having 1 to 6 carbon atoms.

Specific examples of Ar₂ in general formula (3) and Ar₃ in general formula (4) include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

The alkyl group and the aryl group for Rb to Rf in general formula (3) and Ri and Rj in general formula (4) are similar to those described in general formula (2).

Specific examples of the cyanato-substituted aromatic compound represented by general formula (2) include cyanatobenzene, 1-cyanato-2-, 1-cyanato-3-, or 1-cyanato-4-methylbenzene, 1-cyanato-2-, 1-cyanato-3-, or 1-cyanato-4-methoxybenzene, 1-cyanato-2,3-, 1-cyanato-2,4-, 1-cyanato-2,5-, 1-cyanato-2,6-, 1-cyanato-3,4-, or 1-cyanato-3,5-dimethylbenzene, cyanatoethylbenzene, cyanatobutylbenzene, cyanatooctylbenzene, cyanatononylbenzene, 2-(4-cyanaphenyl)-2-phenylpropane (a cyanate of 4-α-cumylphenol), 1-cyanato-4-cyclohexylbenzene, 1-cyanato-4-vinylbenzene, 1-cyanato-2- or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene (a cyanate of eugenol), methyl(4-cyanatophenyl)sulfide, 1-cyanato-3-trifluoromethylbenzene, 4-cyanatobiphenyl, 1-cyanato-2- or 1-cyanato-4-acetylbenzene, 4-cyanatobenzaldehyde, methyl 4-cyanatobenzoate ester, phenyl 4-cyanatobenzoate ester, 1-cyanato-4-acetaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-dimethylbenzene, 1,3-dicyanato-2,4,6-trimethylbenzene, 1,3-dicyanato-5-methylbenzene, 1-cyanato- or 2-cyanatonaphthalene, 1-cyanato4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6-, or 2,7-dicyanatonaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl) ether, bis(4-cyanatophenyl) sulfide, bis(4-cyanatophenyl) sulfone, 4-cyanatobenzoic acid-4-cyanatophenyl ester (4-cyanatophenyl-4-cyanatobenzoate), bis-(4-cyanatophenyl) carbonate, 1,3-bis(4-cyanatophenyl)adamantane, 1,3-bis(4-cyanatophenyl)-5,7-dimethyladamantane, 3,3-bis(4-cyanatophenyl)isobenzofuran-1(3H)-one (a cyanate of phenolphthalein), 3,3-bis(4-cyanato-3-methylphenyl)isobenzofuran-1(3H)-one (a cyanate of o-cresolphthalein), 9,9'-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methylanilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimide, tris(3,5-dimethyl-4-cyanatobenzyl) isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, phenol novolac-based cyanate compounds, cresol novolac-based cyanate compounds, trisphenol novolac-based cyanate compounds, fluorene novolac-based cyanate compounds, phenol aralkyl-based cyanate compounds, cresol aralkyl-based cyanate compounds, naphthol aralkyl-based cyanate compounds, biphenyl aralkyl-based cyanate compounds, phenol-modified xylene formaldehyde-based cyanate compounds, modified naphthalene formaldehyde-based cyanate compounds, phenol-modified dicyclopentadiene-based cyanate compounds, and cyanate compounds of phenolic resins having a polynaphthylene ether structure. One of these cyanate compounds (A) can be used alone, or two or more of these cyanate compounds (A) can be used in combination.

Examples of the phenol novolac-based cyanate compounds and the cresol novolac-based cyanate compounds include those obtained by cyanation of phenol novolac resins and cresol novolac resins by a known method. Examples of the phenol novolac resins and the cresol novolac resins include those obtained by reacting a phenol, an alkyl-substituted phenol, or a halogen-substituted phenol and a formaldehyde compound such as formalin or paraformaldehyde in an acidic solution by a known method.

Examples of the trisphenol novolac-based cyanate compounds include those obtained by cyanation of trisphenol novolac resins by a known method. Examples of the trisphenol novolac resins include those obtained by reacting hydroxybenzaldehyde and a phenol in the presence of an acidic catalyst.

Examples of the fluorene novolac-based cyanate compounds include those obtained by cyanation of fluorene novolac resins by a known method. Examples of the fluorene novolac resins include those obtained by reacting a fluorenone compound and a 9,9-bis(hydroxyaryl)fluorene in the presence of an acidic catalyst.

Examples of the phenol aralkyl-based cyanate compounds, the cresol aralkyl-based cyanate compounds, the naphthol aralkyl-based cyanate compounds, and the biphenyl aralkyl-based cyanate compounds include those obtained by cyanation of phenol aralkyl resins, cresol aralkyl resins, naphthol aralkyl resins, and biphenyl aralkyl resins by a known method. Examples of the phenol aralkyl resins, the cresol aralkyl resins, the naphthol aralkyl resins, and the biphenyl aralkyl resins include those obtained by reacting a bishalogenomethyl compound as represented by Ar₂-(CH₂Y)₂ and a phenol compound with an acidic catalyst or without a catalyst by a known method, those obtained by reacting a bis(alkoxymethyl) compound as represented by Ar₂-(CH₂OR)₂ or a bis(hydroxymethyl) compound as represented by Ar₂-(CH₂OH)₂ and a phenol compound in the presence of an acidic catalyst by a known method, or those obtained by polycondensing an aromatic aldehyde compound, an aralkyl compound, and a phenol compound by a known method.

Examples of the phenol-modified xylene formaldehyde-based cyanate compounds include those obtained by cyanation of phenol-modified xylene formaldehyde resins by a known method. Examples of the phenol-modified xylene formaldehyde resins include those obtained by reacting a xylene formaldehyde resin and a phenol compound in the presence of an acidic catalyst by a known method.

Examples of the modified naphthalene formaldehyde-based cyanate compounds include those obtained by cyanation of modified naphthalene formaldehyde resins by a known method. Examples of the modified naphthalene formaldehyde resins include those obtained by reacting a naphthalene formaldehyde resin and a hydroxy-substituted aromatic compound in the presence of an acidic catalyst by a known method.

Examples of the phenol-modified dicyclopentadiene-based cyanate compounds, and the cyanate compounds of phenolic resins having a polynaphthylene ether structure include those obtained by cyanation of phenol-modified dicyclopentadiene resins, and phenolic resins having a polynaphthylene ether structure by a known method. Examples of the phenol-modified dicyclopentadiene resins, and the phenolic resins having a polynaphthylene ether structure include those obtained by subjecting a polyvalent hydroxynaphthalene compound having two or more phenolic hydroxy groups in one molecule to dehydration condensation in the presence of a basic catalyst by a known method.

Among the above-described, naphthol aralkyl-based cyanate compounds are essential to the present invention insofar as the cyanate compound (a) comprises a naphthol aralkyl-based cyanate compound.

Cured products obtained from resin compositions using these cyanate compounds (A) have excellent heat resistance and also excellent plating adhesiveness due to high glass transition temperature. Particularly cured products obtained from resin compositions using naphthol aralkyl-based cyanate compounds according to the invention have an excellent balance between heat resistance and plating adhesiveness.

The content of the cyanate compound (A) can be appropriately set according to the desired characteristics and is not particularly limited but is preferably 1 to 90 parts by mass, more preferably 10 to 85 parts by mass, further preferably 30 to 75 parts by mass, and still further preferably 40 to 60 parts by mass based on the total amount (100 parts by mass) of resin solids in the resin composition. When the content of the cyanate compound (A) is 1 part by mass or more, better heat resistance tends to be obtained. In addition, when the content of the cyanate compound (A) is 90 parts by mass or less, better plating peel strength tends to be obtained. Here, the "resin solids in the resin composition" refers to components in the resin composition excluding components other than resins, such as a solvent and a filler (C), unless otherwise noted, and "the total amount of resin solids" refers to the total amount of the components in the resin composition excluding the components other than the resins, such as the solvent and the filler (C).

### <Epoxy Resin (B)>

The epoxy resin (B) in this embodiment is represented by the following general formula (1): 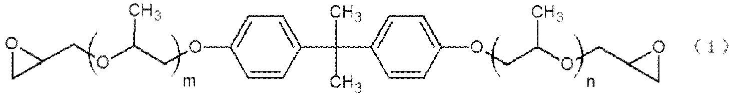 wherein m and n represent an integer of 1 or more. The epoxy resin (B) represented by general formula (1) may be a mixture of compounds in which m and n each independently represent a different integer.

The viscosity of the epoxy resin (B) represented by general formula (1) is not particularly limited but is preferably 10 mPa·s/25°C or more and 20000 mPa·s/25°C or less, more preferably 100 mPa·s/25°C or more and 10000 mPa·s/25°C or less, further preferably 500 mPa·s/25°C or more and 5000 mPa·s/25°C or less, and still further preferably 1000 mPa·s/25°C or more and 2500 mPa·s/25°C or less. When the viscosity is in the above range, better plating peel strength tends to be able to be obtained. Such an epoxy resin (B) that the viscosity is in the above range can be appropriately selected from commercial ones, and these may be combined.

The epoxy resin (B) represented by general formula (1) is not particularly limited as long as it is represented by general formula (1). Commercial ones may be used, and, for example, the trade name "EP-4000S" manufactured by ADEKA CORPORATION is preferred.

The content of the epoxy resin (B) represented by general formula (1) can be appropriately set according to the desired characteristics and is not particularly limited but is preferably 1 to 90 parts by mass, more preferably 20 to 75 parts by mass, further preferably 40 to 60 parts by mass based on the total amount (100 parts by mass) of the resin solids in the resin composition. When the content of the epoxy resin (B) is 1 part by mass or more, better plating peel strength tends to be obtained. In addition, when the content of the epoxy resin (B) is 90 parts by mass or less, better heat resistance tends to be obtained.

### <Filler (C)>

The resin composition in this embodiment preferably further contains the filler (C). By containing the filler (C), the mechanism of the present invention can be more reliably achieved, and excellent plating peel strength tends to be obtained. In addition, the mechanism of the cyanate compound (A) in this embodiment can be more reliably achieved, and excellent heat resistance also tends to be obtained.

As the filler (C), known ones can be appropriately used, and the type of the filler (C) is not particularly limited. Those generally used in the industry can be preferably used. Specific examples include inorganic fillers such as silicas such as natural silica, fused silica, synthetic silica, amorphous silica, AEROSIL, and hollow silica, white carbon, titanium white, zinc oxide, magnesium oxide, zirconium oxide, boron nitride, aggregated boron nitride, silicon nitride, aluminum nitride, barium sulfate, metal hydrates such as aluminum hydroxide, heat-treated products of aluminum hydroxide (products obtained by heat-treating aluminum hydroxide to decrease some of the water of crystallization), boehmite, and magnesium hydroxide, molybdenum compounds such as molybdenum oxide and zinc molybdate, zinc borate, zinc stannate, alumina, clay, kaolin, talc, calcined clay, calcined kaolin, calcined talc, mica, E-glass, A-glass, NE-glass, C-glass, L-glass, D-glass, S-glass, M-glass G20, glass short fibers (including fine powders of glass such as E glass, T glass, D glass, S glass, and Q glass), hollow glass, and spherical glass as well as organic fillers such as rubber powders such as styrene-based rubber powders, butadiene-based rubber powders, and acrylic rubber powders, core-shell-based rubber powders, silicone resin powders, silicone rubber powders, and silicone composite powders. One of these fillers (C) can be used alone, or two or more of these fillers (C) can be used in combination.

By containing these fillers (C), the characteristics, such as plating peel strength, thermal expansion characteristics, dimensional stability, and flame retardancy, of the resin composition tend to improve more.

The content of the filler (C) in the resin composition in this embodiment can be appropriately set according to the desired characteristics and is not particularly limited but is preferably 50 to 1600 parts by mass, more preferably 60 to 1000 parts by mass, further preferably 70 to 500 parts by mass, and still further preferably 80 to 200 parts by mass based on the total amount (100 parts by mass) of the resin solids in the resin composition. By setting the content of the filler (C) at 50 to 1600 parts by mass, the moldability of the resin composition tends to be good.

Here, when the filler (C) is used, a silane coupling agent and a wetting and dispersing agent are preferably used in combination. As the silane coupling agent, those generally used for surface treatment of inorganic matter can be preferably used, and the type of the silane coupling agent is not particularly limited. Specific examples include aminosilane-based such as γ-aminopropyltriethoxysilane and N-β-(aminoethyl)-γ-aminopropyltrimethoxysilane; epoxysilane-based such as γ-glycidoxypropyltrimethoxysilane and β-(3,4-epoxycyclohexyl)ethyltrimethoxysilane; vinylsilane-based such as γ-methacryloxypropyltrimethoxysilane and vinyl-tri(β-methoxyethoxy)silane; cationic silane-based such as N-β-(N-vinylbenzylaminoethyl)-γ-aminopropyltrimethoxysilane hydrochloride; and phenylsilane-based. One of these silane coupling agent can be used alone, or two or more of these silane coupling agents can be used in combination. In addition, as the wetting and dispersing agent, those generally used for paints can be preferably used, and the type of the wetting and dispersing agent is not particularly limited. Preferably, copolymer-based wetting and dispersing agents are used. Specific examples thereof include Disperbyk-110, 111, 161, and 180, BYK-W996, BYK-W9010, BYK-W903, and BYK-W940 manufactured by BYK Japan KK. One of these wetting and dispersing agent can be used alone, or two or more of these wetting and dispersing agents can be used in combination.

### <Other Components>

Further, the resin composition in this embodiment may contain other components as needed. The other components are not particularly limited. Examples thereof include any one or more selected from the group consisting of an epoxy resin other than the above epoxy resin (B) (hereinafter referred to as "another epoxy resin"), a maleimide compound, a phenolic resin, an oxetane resin, a benzoxazine compound, and a compound having a polymerizable unsaturated group. By using such other components, the desired characteristics, such as flame retardancy and low dielectric properties, of a cured product obtained by curing the resin composition can be improved.

As the another epoxy resin, known ones can be appropriately used as long as they are epoxy resins that do not have the structural units represented by general formula (1) and that have two or more epoxy groups in one molecule. The type of the another epoxy resin is not particularly limited. Specific examples include bisphenol A-based epoxy resins, bisphenol E-based epoxy resins, bisphenol F-based epoxy resins, bisphenol S-based epoxy resins, phenol novolac-based epoxy resins, bisphenol A novolac-based epoxy resins, glycidyl ester-based epoxy resins, aralkyl novolac-based epoxy resins, biphenyl aralkyl-based epoxy resins, naphthylene ether-based epoxy resins, cresol novolac-based epoxy resins, polyfunctional phenol-based epoxy resins, naphthalene-based epoxy resins, anthracene-based epoxy resins, naphthalene skeleton-modified novolac-based epoxy resins, phenol aralkyl-based epoxy resins, naphthol aralkyl-based epoxy resins, dicyclopentadiene-based epoxy resins, biphenyl-based epoxy resins, alicyclic epoxy resins, polyol-based epoxy resins, phosphorus-containing epoxy resins, glycidyl amines, glycidyl esters, compounds obtained by epoxidizing double bonds of butadiene and the like, and compounds obtained by reaction of hydroxyl group-containing silicone resins and epichlorohydrin. Among these another epoxy resins, biphenyl aralkyl-based epoxy resins, naphthylene ether-based epoxy resins, polyfunctional phenol-based epoxy resins, and naphthalene-based epoxy resins are preferred. By using such another epoxy resin, the flame retardancy and the heat resistance tend to improve more. One of these epoxy resins can be used alone, or two or more of these epoxy resins can be used in combination.

As the maleimide compound, those generally known can be used as long as they are compounds having one or more maleimide groups in one molecule. The type of the maleimide compound is not particularly limited. Specific examples include 4,4-diphenylmethanebismaleimide, phenylmethanemaleimide, m-phenylenebismaleimide, 2,2-bis(4-(4-maleimidophenoxy)-phenyl)propane, 3,3-dimethyl-5,5-diethyl-4,4-diphenylmethanebismaleimide, 4-methyl-1,3-phenylenebismaleimide, 1,6-bismaleimido-(2,2,4-trimethyl)hexane, 4,4-diphenyl ether bismaleimide, 4,4-diphenyl sulfone bismaleimide, 1,3-bis(3-maleimidophenoxy)benzene, 1,3-bis(4-maleimidophenoxy)benzene, polyphenylmethanemaleimide, novolac-based maleimides, biphenyl aralkyl-based maleimides, and prepolymers of these maleimide compounds and prepolymers of maleimide compounds and amine compounds. Among these, novolac-based maleimide compounds and biphenyl aralkyl-based maleimide compounds are more preferred. One of these maleimide compounds can be used alone, or two or more of these maleimide compounds can be used in combination.

As the phenolic resin, those generally known can be used as long as they are phenolic resins having two or more hydroxyl groups in one molecule. The type of the phenolic resin is not particularly limited. Specific examples of the phenolic resin include bisphenol A-based phenolic resins, bisphenol E-based phenolic resins, bisphenol F-based phenolic resins, bisphenol S-based phenolic resins, phenol novolac resins, bisphenol A novolac-based phenolic resins, glycidyl ester-based phenolic resins, aralkyl novolac-based phenolic resins, biphenyl aralkyl-based phenolic resins, cresol novolac-based phenolic resins, polyfunctional phenolic resins, naphthol resins, naphthol novolac resins, polyfunctional naphthol resins, anthracene-based phenolic resins, naphthalene skeleton-modified novolac-based phenolic resins, phenol aralkyl-based phenolic resins, naphthol aralkyl-based phenolic resins, dicyclopentadiene-based phenolic resins, biphenyl-based phenolic resins, alicyclic phenolic resins, polyol-based phenolic resins, phosphorus-containing phenolic resins, and hydroxyl group-containing silicone resins. Among these phenolic resins, biphenyl aralkyl-based phenolic resins, naphthol aralkyl-based phenolic resins, phosphorus-containing phenolic resins, and hydroxyl group-containing silicone resins are more preferred in terms of flame retardancy. One of these phenolic resins can be used alone, or two or more of these phenolic resins can be used in combination.

As the oxetane resin, those generally known can be used, and the type of the oxetane resin is not particularly limited. Specific examples of the oxetane resin include oxetane, alkyloxetanes such as 2-methyloxetane, 2,2-dimethyloxetane, 3-methyloxetane, and 3,3-dimethyloxetane, 3-methyl-3-methoxymethyloxetane, 3,3-di(trifluoromethyl)perfluoxetane, 2-chloromethyloxetane, 3,3-bis(chloromethyl)oxetane, biphenyl-based oxetane, OXT-101 (trade name manufactured by Toagosei Co., Ltd.), and OXT-121 (trade name manufactured by Toagosei Co., Ltd.). One of these oxetane resins can be used alone, or two or more of these oxetane resins can be used in combination.

As the benzoxazine compound, those generally known can be used as long as they are compounds having two or more dihydrobenzoxazine rings in one molecule. The type of the benzoxazine compound is not particularly limited. Specific examples include bisphenol A-based benzoxazine BA-BXZ (trade name manufactured by Konishi Chemical Ind. Co., Ltd.), bisphenol F-based benzoxazine BF-BXZ (trade name manufactured by Konishi Chemical Ind. Co., Ltd.), and bisphenol S-based benzoxazine BS-BXZ (trade name manufactured by Konishi Chemical Ind. Co., Ltd.). One of these benzoxazine compounds can be used alone, or two or more of these benzoxazine compounds can be used in combination.

As the compound having a polymerizable unsaturated group, those generally known can be used, and the type of the compound having a polymerizable unsaturated group is not particularly limited. Specific examples of the compound having a polymerizable unsaturated group include vinyl compounds such as ethylene, propylene, styrene, divinylbenzene, and divinylbiphenyl; (meth)acrylates of monohydric or polyhydric alcohols such as methyl (meth)acrylate, 2-hydroxyethyl (meth)acrylate, 2-hydroxypropyl (meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy (meth)acrylates such as bisphenol A-based epoxy (meth)acrylate and bisphenol F-based epoxy (meth)acrylate; benzocyclobutene resins; and (bis)maleimide resins. One of these compounds having an unsaturated group can be used alone, or two or more of these compounds having an unsaturated group can be used in combination.

In addition, the resin composition in this embodiment may further contain a curing accelerator for appropriately adjusting the curing rate, as needed. As this curing accelerator, those generally used as curing accelerators for cyanate compounds, epoxy resins, and the like can be preferably used, and the type of the curing accelerator is not particularly limited. Specific examples thereof include organometallic salts such as zinc octylate, zinc naphthenate, cobalt naphthenate, copper naphthenate, acetylacetone iron, nickel octylate, and manganese octylate; phenol compounds such as phenol, xylenol, cresol, resorcin, catechol, octyl phenol, and nonyl phenol; alcohols such as 1-butanol and 2-ethylhexanol; imidazoles such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole and derivatives such as adducts of carboxylic acids of these imidazoles or acid anhydrides thereof; amines such as dicyandiamide, benzyldimethylamine, and 4-methyl-N,N-dimethylbenzylamine; phosphorus compounds such as phosphine-based compounds, phosphine oxide-based compounds, phosphonium salt-based compounds, and diphosphine-based compounds, peroxides such as epoxy-imidazole adduct-based compounds, benzoyl peroxide, p-chlorobenzoyl peroxide, di-t-butyl peroxide, diisopropyl peroxycarbonate, and di-2-ethylhexyl peroxycarbonate; and azo compounds such as azobisisobutyronitrile. One of these curing accelerator can be used alone, or two or more of these curing accelerators can be used in combination.

The content of the curing accelerator can be appropriately adjusted considering the degrees of cure of the resins, the viscosity of the resin composition, and the like and is not particularly limited but is preferably 0.005 to 10 parts by mass based on the total amount (100 parts by mass) of the resin solids in the resin composition.

Further, various polymer compounds such as another thermosetting resin, a thermoplastic resin, an oligomer thereof, and an elastomer, a flame-retardant compound, various additives, and the like can be used in combination in the resin composition in this embodiment in a range in which the expected characteristics are not impaired. These are not particularly limited as long as they are those generally used. Specific examples of the flame-retardant compound include bromine compounds such as 4,4'-dibromobiphenyl, phosphates, melamine phosphate, phosphorus-containing epoxy resins, nitrogen compounds such as melamine and benzoguanamine, oxazine ring-containing compounds, and silicone-based compounds. In addition, examples of the various additives include ultraviolet absorbing agents, antioxidants, photopolymerization initiators, fluorescent brightening agents, photosensitizers, dyes, pigments, thickening agents, flow-adjusting agents, lubricants, defoaming agents, dispersing agents, leveling agents, brightening agents, and polymerization inhibitors. One of these can be used alone or two or more of these can be used in combination as desired.

The resin composition in this embodiment can contain an organic solvent as needed. In this case, the resin composition of the present invention can be used as a form (solution or varnish) in which at least some, preferably all, of the above-described various resin components are dissolved in or compatible with the organic solvent. As the organic solvent, known ones can be appropriately used as long as they can dissolve or be compatible with at least some, preferably all, of the above-described various resin components. The type of the organic solvent is not particularly limited. Specific examples include polar solvents such as ketones such as acetone, methyl ethyl ketone, and methyl isobutyl ketone; cellosolve-based solvents such as propylene glycol monomethyl ether and propylene glycol monomethyl ether acetate; ester-based solvents such as ethyl lactate, methyl acetate, ethyl acetate, butyl acetate, isoamyl acetate, ethyl lactate, methyl methoxypropionate, and methyl hydroxyisobutyrate; and amides such as dimethylacetamide and dimethylformamide; and nonpolar solvents such as aromatic hydrocarbons such as toluene and xylene. One of these can be used alone, or two or more of these can be used in combination.

### <Method for Producing Resin Composition>

The resin composition in this embodiment can be produced according to an ordinary method, and the method for preparing the resin composition in this embodiment is not particularly limited as long as it is a method in which a resin composition uniformly containing the cyanate compound (A) and the epoxy resin (B) represented by general formula (1) and the above-described other optional components is obtained. For example, the resin composition in this embodiment can be easily produced by sequentially blending the cyanate compound (A) and the epoxy resin (B) represented by general formula (1) with a solvent and sufficiently stirring the blend.

During preparation of the resin composition, known treatment (stirring, mixing, and kneading treatment and the like) for uniformly dissolving or dispersing the components can be performed. For example, in uniform dispersion of the filler (C), by performing stirring and dispersion treatment using a stirring vessel provided with a stirrer having suitable stirring ability, the dispersibility in the resin composition is increased. The above stirring, mixing, and kneading treatment can be appropriately performed, for example, using a known apparatus such as an apparatus intended for mixing such as a ball mill or a bead mill, or a revolution-rotation mixing apparatus.

The resin composition in this embodiment is not particularly limited and can be used as a material for an insulating layer of a printed wiring board and a semiconductor package material. For example, a prepreg can be provided by impregnating or coating a base material with a solution of the resin composition in this embodiment dissolved in a solvent and drying the solution.

In addition, a resin sheet can be provided by using a peelable plastic film as a support, coating the plastic film with a solution of the resin composition in this embodiment dissolved in a solvent, and drying the solution. The resin sheet can be used as a buildup film or a dry film solder resist. Here, the solvent can be dried by heating at a temperature of 20°C to 150°C for 1 to 90 minutes. In addition, the resin composition can also be used in an uncured state in which the solvent is only dried, or in a semi-cured (B-staged) state as needed.

### <Prepreg>

A prepreg in this embodiment will be described in detail below. The prepreg in this embodiment comprises a base material; and the resin composition in this embodiment described above with which the base material is impregnated or coated. The method for producing the prepreg is not particularly limited as long as it is a method of combining the resin composition in this embodiment and a base material to produce a prepreg. The prepreg is obtained by impregnating or coating a base material with the resin composition in this embodiment. More specifically, the prepreg in this embodiment can be produced by impregnating or coating a base material with the resin composition in this embodiment and then semi-curing the resin composition by a method of drying at 120 to 220°C for about 2 to 15 minutes, or the like. At this time, the amount of the resin composition adhered to the base material, that is, the amount of the resin composition (including the filler (C)) based on the total amount (100 parts by mass) of the prepreg after the semi-curing, is preferably in the range of 20 to 99 parts by mass.

The base material in this embodiment is not particularly limited, and, for example, known ones used for various printed wiring board materials can be used. Specific examples of the base material include woven fabrics of fibers of glass such as E glass, D glass, L glass, S glass, T glass, Q glass, UN glass, NE glass, and spherical glass; inorganic fibers of materials other than glass, such as quartz; organic fibers of polyimides, polyamides, polyesters, and the like; liquid crystal polyesters; and the like. As the shape of the base material, woven fabrics, nonwoven fabrics, rovings, chopped strand mats, surfacing mats, and the like are known, and the shape of the base material may be any. One of these base material can be used alone, or two or more of these base materials can be used in combination. In addition, the thickness of the base material is not particularly limited, but is preferably in the range of 0.01 to 0.2 mm in laminate applications. Particularly, woven fabrics subjected to ultra-opening treatment or clogging treatment are preferred from the viewpoint of dimensional stability. Further, glass woven fabrics surface-treated with silane coupling agents for epoxysilane treatment, aminosilane treatment, and the like are preferred from the viewpoint of moisture absorption heat resistance. In addition, liquid crystal polyester woven fabrics are preferred in terms of electrical characteristics.

### <Metal Foil-Clad Laminate>

A metal foil-clad laminate in this embodiment comprises one of the above-described prepreg or two or more of the above-described prepregs laminated; and metal foil laminate-molded on one surface or both surfaces of the prepreg. Specifically, the metal foil-clad laminate in this embodiment can be produced by stacking one or a plurality of the above-described prepregs, disposing foil of a metal such as copper or aluminum on one surface or both surfaces of the stack, and laminate-molding the metal foil and the stack. The metal foil used here is not particularly limited as long as it is one used for a printed wiring board material. Copper foil such as rolled copper foil and electrolytic copper foil is preferred. In addition, the thickness of the metal foil is not particularly limited but is preferably 2 to 70 µm, more preferably 3 to 35 µm. As the molding conditions, usual methods for laminates and multilayer boards for printed wiring boards can be applied. For example, the metal foil-clad laminate in this embodiment can be produced by laminate-molding with a temperature of 180 to 350°C, a heating time of 100 to 300 minutes, and a surface pressure of 20 to 100 kg/cm² using a multistage press, a multistage vacuum press, a continuous molding machine, an autoclave molding machine, or the like. In addition, a multilayer board can also be provided by laminate-molding the above prepreg and a separately fabricated wiring board for an inner layer in combination. As the method for producing a multilayer board, for example, a multilayer board can be fabricated by disposing 35 µm copper foil on both surfaces of one of the above-described prepreg, laminating and forming the copper foil and the prepreg under the above conditions, then forming inner layer circuits, subjecting these circuits to blackening treatment to form an inner layer circuit board, then alternately disposing these inner layer circuit boards and the above prepregs one by one, further disposing copper foil on the outermost layers, and laminate-molding the copper foil, the inner layer circuit boards, and the prepregs under the above conditions preferably under vacuum.

The metal foil-clad laminate in this embodiment can be preferably used as a printed wiring board. The printed wiring board can be produced according to an ordinary method, and the method for producing the printed wiring board is not particularly limited. One example of a method for producing a printed wiring board will be shown below. First, a metal foil-clad laminate such as the above-described copper-clad laminate is provided. Next, the surfaces of the metal foil-clad laminate are subjected to etching treatment to form inner layer circuits to fabricate an inner layer board. The inner layer circuit surfaces of this inner layer board are subjected to surface treatment for increasing adhesive strength, as needed. Then, the required number of the above-described prepregs are stacked on the inner layer circuit surfaces, metal foil for outer layer circuits is further laminated on the outside of the stack, and heat and pressure are applied for integral molding. In this manner, a multilayer laminate in which insulating layers comprising a base material and a cured product of a thermosetting resin composition are formed between inner layer circuits and metal foil for outer layer circuits is produced. Then, this multilayer laminate is subjected to perforation for through holes and via holes, and then plating metal films that allow conduction between the inner layer circuits and the metal foil for outer layer circuits are formed on the wall surfaces of these holes. Further, the metal foil for outer layer circuits is subjected to etching treatment to form outer layer circuits. Thus, a printed wiring board is produced.

### <Printed wiring board>

A printed wiring board in this embodiment comprises an insulating layer comprising the resin composition in this embodiment described above; and a conductor layer formed on one surface or both surfaces of the insulating layer. In other words, the prepreg in this embodiment described above (the base material and the resin composition in this embodiment with which the base material is impregnated or coated) and the resin composition layer of the metal foil-clad laminate in this embodiment described above (the layer comprising the resin composition in this embodiment) are composed of an insulating layer comprising the resin composition in this embodiment.

### <Resin Sheet>

A resin sheet in this embodiment comprises a sheet base material; and the resin composition in this embodiment described above with which one surface or both surfaces of the sheet base material is coated and which is dried. The resin sheet can be obtained by coating a sheet base material with a solution of the resin composition dissolved in a solvent (resin composition) and drying the solution. Examples of the sheet base material used here are not particularly limited and include organic film base materials such as polyethylene films, polypropylene films, polycarbonate films, polyethylene terephthalate films, ethylene-tetrafluoroethylene copolymer films, and release films obtained by coating surfaces of these films with release agents, and polyimide films; conductor foil such as copper foil and aluminum foil; and plate-shaped supports such as glass plates, SUS plates, and FRP. Examples of the method for coating include a method of coating a support with a solution of the resin composition in this embodiment dissolved in a solvent by a bar coater, a die coater, a doctor blade, a baker applicator, or the like. In addition, a single-layer sheet (resin sheet) can also be provided by peeling or etching the support from the laminated sheet after drying. A single-layer sheet (resin sheet) can also be obtained without using a support by supplying a solution of the above resin composition in this embodiment dissolved in a solvent into a mold having a sheet-shaped cavity, and drying the solution, or the like for molding into a sheet shape.

In fabrication of the single-layer or laminated sheet in this embodiment, the drying conditions when the solvent is removed are not particularly limited but are preferably a temperature of 20°C to 200°C for 1 to 90 minutes because at low temperature, the solvent is likely to remain in the resin composition, and at high temperature, curing of the resin composition proceeds. In addition, the thickness of the resin layer of the single-layer sheet or laminated sheet in this embodiment can be adjusted by the concentration and coating thickness of the solution of the resin composition in this embodiment and is not particularly limited but is preferably 0.1 to 500 µm because generally, when the coating thickness increases, the solvent is likely to remain during drying.

### Examples

The present invention will be described in more detail below by showing Synthesis Examples, an Example, and a Comparative Example, but the present invention is not limited to these.

### (Synthesis Example 1) Synthesis of Cyanate Compound

300 g (1.28 mol in terms of OH groups) of a 1-naphthol aralkyl resin (manufactured by NIPPON STEEL & SUMIKIN CHEMICAL CO., LTD.) and 194.6 g (1.92 mol) (1.5 mol based on 1 mol of hydroxy groups) of triethylamine were dissolved in 1800 g of dichloromethane, and this solution was a solution 1.

While 125.9 g (2.05 mol) (1.6 mol based on 1 mol of hydroxy groups) of cyanogen chloride, 293.8 g of dichloromethane, 194.5 g (1.92 mol) (1.5 mol based on 1 mol of hydroxy groups) of 36% hydrochloric acid, and 1205.9 g of water were kept at a liquid temperature of -2 to -0.5°C under stirring, the solution 1 was poured over 30 minutes. After completion of pouring of the solution 1, the mixture was stirred at the same temperature for 30 minutes, and then a solution of 65 g (0.64 mol) (0.5 mol based on 1 mol of hydroxy groups) of triethylamine dissolved in 65 g of dichloromethane (solution 2) was poured over 10 minutes. After completion of pouring of the solution 2, the mixture was stirred at the same temperature for 30 minutes to complete the reaction.

Then, the reaction liquid was allowed to stand to separate the organic phase and the aqueous phase. The obtained organic phase was washed five times with 1300 g of water. The electrical conductivity of the wastewater from the fifth water washing was 5 µS/cm, and it was confirmed that removable ionic compounds were sufficiently removed by the washing with water.

The organic phase after the water washing was concentrated under reduced pressure and finally concentrated to dryness at 90°C for 1 hour to obtain 331 g of the target naphthol aralkyl-based cyanate compound (SNCN) (orange viscous material). The mass average molecular weight Mw of the obtained SNCN was 600. In addition, the IR spectrum of SNCN showed absorption at 2250 cm⁻¹ (cyanate groups) and showed no absorption of hydroxy groups.

### (Example 1)

50 parts by mass of the SNCN obtained by Synthesis Example 1, 50 parts by mass of an epoxy resin represented by the following general formula (1) (EP-4000S, viscosity: 1800 mPa·s/25°C, manufactured by ADEKA CORPORATION), 100 parts by mass of fused silica (SC2050MB, manufactured by Admatechs Company Limited), and 0.15 parts by mass of zinc octylate (manufactured by Nihon Kagaku Sangyo Co., Ltd.) were mixed to obtain a varnish. This varnish was diluted with methyl ethyl ketone, and an E-glass woven fabric having a thickness of 0.1 mm was impregnated and coated with the diluted varnish and heated and dried at 150°C for 5 minutes to obtain a prepreg having a resin content of 50% by mass. 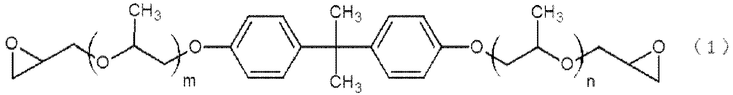 wherein m and n represent an integer of 1 or more; and the epoxy resin represented by formula (1) may be a mixture of compounds in which m and n each independently represent a different integer.

Eight of the obtained prepregs were stacked, and 12 µm thick electrolytic copper foil (3EC-M3-VLP, manufactured by MITSUI MINING & SMELTING CO., LTD.) was disposed on the top and the bottom. The stack was laminate-molded at a pressure of 30 kgf/cm² and a temperature of 220°C for 120 minutes to obtain a metal foil-clad laminate having an insulating layer thickness of 0.8 mm. Evaluation of plating peel strength, a bending elastic modulus, and a dielectric constant was performed using the obtained metal foil-clad laminate. The evaluation results are shown in Table 1.

### (Comparative Example 1)

A metal foil-clad laminate having a thickness of 0.8 mm was obtained as in Example 1 except that 50 parts by mass of a biphenyl aralkyl-based epoxy resin (NC-3000-FH, manufactured by Nippon Kayaku Co., Ltd.) and 0.12 parts by mass of zinc octylate were used instead of using 50 parts by mass of the epoxy resin represented by general formula (1) in Example 1. The evaluation results of the obtained metal foil-clad laminate are shown in Table 1.

### (Measurement Methods and Evaluation Methods)

Plating peel strength: For each of the metal foil-clad laminates having an insulating layer thickness of 0.8 mm obtained in Example 1 and Comparative Example 1, electroless copper plating of about 0.8 µm was provided by the process of electroless copper plating manufactured by C. Uyemura & Co., Ltd. (names of chemical solutions used: MCD-PL, MDP-2, MAT-SP, MAB-4-C, MEL-3-APEA ver. 2), and drying was performed at 130°C for 1 hour. Next, electrolytic copper plating was provided so that the thickness of plating copper was 18 µm, and drying was performed at 180°C for 1 hour. In this manner, a sample in which a conductor layer (plating copper) having a thickness of 18 µm was formed on an insulating layer was fabricated and evaluated. The adhesive force of the plating copper was measured three times in accordance with JIS C6481, and the average value was obtained.

Bending elastic modulus: The copper foil on both surfaces of each of the metal foil-clad laminates having an insulating layer thickness of 0.8 mm obtained in Example 1 and Comparative Example 1 was removed by etching. Then, in accordance with JIS C6481, using a test piece (50 mm × 25 mm × 0.8 mm), the bending strength elastic modulus was measured with the number of tests being 5, and the average value of the maximum values was obtained.

Dielectric constant (Dk): Using a test piece obtained by removing the copper foil of each of the metal foil-clad laminates having an insulating layer thickness of 0.8 mm obtained in Example 1 and Comparative Example 1 by etching, the dielectric constant at 1 GHz was measured three times by a cavity resonator perturbation method (Agilent 8722ES, manufactured by Agilent Technologies), and the average value was obtained.

**[Table 1]**

| | | Example 1 | Comparative Example 1 |
|---|---|---|---|
| Plating peel strength | [kN/m] | 0.74 | 0.53 |
| Bending elastic modulus | [GPa] | 28.3 | 30.4 |
| Dielectric constant | Dk(10 GHz) | 4.5 | 4.5 |

As is clear from Table 1, it was at least confirmed that by using the resin composition of the Example, a prepreg, a printed wiring board, and the like having excellent plating peel strength were realized.

This application is based on Japanese Patent Application No. 2015-091041 filed with the Japan Patent Office on April 28, 2015.

### Industrial Applicability

As described above, the resin composition according to the present invention can be widely and effectively used in various applications such as electrical and electronic materials, machine tool materials, and aviation materials, for example, as electrical insulating materials, semiconductor plastic packages, sealing materials, adhesives, lamination materials, resists, and buildup laminate materials, and, particularly, can be especially effectively used as printed wiring board materials adapted to higher integration and higher density for information terminal equipment, communication equipment, and the like in recent years. In addition, the metal foil-clad laminate and the like according to the present invention have performance excellent in plating peel strength, and therefore their industrial practicality is extremely high.

## Claims

1. A resin composition comprising a cyanate compound (A), wherein the cyanate compound (A) comprises a naphthol aralkyl-based cyanate compound; and an epoxy resin (B) represented by following general formula (1): 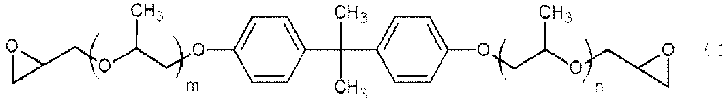 wherein m and n each independently represent an integer of 1 or more; and the epoxy resin (B) represented by the general formula (1) may be a mixture of compounds in which m and n each independently represent a different integer.

2. The resin composition according to claim 1, wherein a content of the epoxy resin (B) represented by the general formula (1) is 1 to 90 parts by mass based on a total amount (100 parts by mass) of resin solids in the resin composition.

3. The resin composition according to claim 1 or 2, further comprising a filler (C).

4. The resin composition according to claim 1, wherein the filler (C) comprises silica.

5. The resin composition according to any one of claims 1 to 4, further comprising one or two or more selected from the group consisting of an epoxy resin other than the epoxy resin (B) represented by the general formula (1), a maleimide compound, a phenolic resin, an oxetane resin, a benzoxazine compound, and a compound having a polymerizable unsaturated group.

6. The resin composition according to claim 3, 4 or 5, wherein a content of the filler (C) is 50 to 1600 parts by mass based on a total amount (100 parts by mass) of the resin solids in the resin composition.

7. A prepreg comprising:
a base material; and the resin composition according to any one of claims 1 to 6 with which the base material is impregnated or coated.

8. A metal foil-clad laminate comprising one of the prepreg according to claim 7 or two or more of the prepregs according to claim 7 laminated; and metal foil laminate-molded on one surface or both surfaces of the prepreg.

9. A resin sheet comprising a sheet base material; and the resin composition according to any one of claims 1 to 6 with which one surface or both surfaces of the sheet base material is coated and which is dried.

10. A printed wiring board comprising an insulating layer comprising the resin composition according to any one of claims 1 to 6; and a conductor layer formed on one surface or both surfaces of the insulating layer.

## Patentansprüche

1. Harzzusammensetzung, umfassend eine Cyanatverbindung (A), wobei die Cyanatverbindung (A) eine Naphthol-Aralkyl-basierte Cyanatverbindung umfasst, und ein durch die folgende allgemeine Formel (1) dargestelltes Epoxidharz (B): 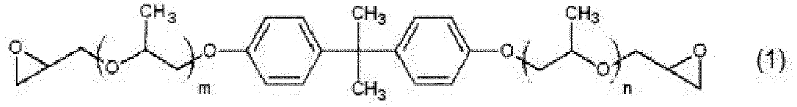 worin m und n jeweils unabhängig eine ganze Zahl von 1 oder größer darstellen und das durch die allgemeine Formel (1) dargestellte Epoxidharz (B) eine Mischung aus Verbindungen sein kann, in denen m und n jeweils unabhängig eine unterschiedliche ganze Zahl darstellen.

2. Harzzusammensetzung gemäß Anspruch 1, wobei ein Gehalt des durch die allgemeine Formel (1) dargestellten Epoxidharzes (B) 1 bis 90 Masseteile, bezogen auf eine Gesamtmenge (100 Masseteile) der Harzfeststoffe in der Harzzusammensetzung, beträgt.

3. Harzzusammensetzung gemäß Anspruch 1 oder 2, ferner umfassend einen Füllstoff (C).

4. Harzzusammensetzung gemäß Anspruch 1, wobei der Füllstoff (C) Silika umfasst.

5. Harzzusammensetzung gemäß irgendeinem der Ansprüche 1 bis 4, ferner umfassend eines oder zwei oder mehrere, ausgewählt aus der Gruppe, bestehend aus einem Epoxidharz, das sich von dem durch die allgemeine Formel (1) dargestellten Epoxidharz (B) unterscheidet, einer Maleimidverbindung, einem Phenolharz, einem Oxetanharz, einer Benzoxazinverbindung und einer Verbindung mit einer polymerisierbaren ungesättigten Gruppe.

6. Harzzusammensetzung gemäß Anspruch 3, 4 oder 5, wobei der Gehalt des Füllstoffs (C) 50 bis 1.600 Masseteile, bezogen auf eine Gesamtmenge (100 Masseteile) der Harzfeststoffe in der Harzzusammensetzung, beträgt.

7. Prepreg, umfassend:
ein Basismaterial und die Harzzusammensetzung gemäß irgendeinem der Ansprüche 1 bis 6, mit der das Basismaterial imprägniert oder beschichtet ist.

8. Metallfolien-kaschiertes Laminat, umfassend ein Prepreg gemäß Anspruch 7 oder zwei oder mehrere laminierte Prepregs gemäß Anspruch 7 und eine auf einer Oberfläche oder beiden Oberflächen des Prepregs durch Laminierung gebildete Metallfolie.

9. Harzplatte, umfassend eine Basismaterialplatte und die Harzzusammensetzung gemäß irgendeinem der Ansprüche 1 bis 6, mit der eine Oberfläche oder beide Oberflächen der Basismaterialplatte beschichtet ist und die getrocknet ist.

10. Gedruckte Verdrahtungsplatte, umfassend eine Isolierschicht, umfassend die Harzzusammensetzung gemäß irgendeinem der Ansprüche 1 bis 6, und eine Leiterschicht, die auf einer Oberfläche oder beiden Oberflächen der Isolierschicht gebildet ist.

## Revendications

1. Composition de résine comprenant un composé cyanate (A), dans laquelle le composé cyanate (A) comprend un composé cyanate à base de naphtol aralkyle ; et une résine époxy (B) représentée par la formule générale (1) suivante : 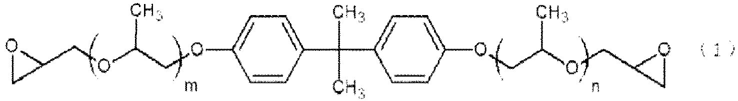 dans laquelle m et n représentent chacun indépendamment un nombre entier supérieur ou égal à 1 ; et la résine époxy (B) représentée par la formule générale (1) peut être un mélange de composés dans lequel m et n représentent chacun indépendamment un nombre entier différent.

2. Composition de résine selon la revendication 1, dans laquelle une teneur en résine époxy (B) représentée par la formule générale (1) va de 1 à 90 parties en masse en fonction d'une quantité totale (100 parties en masse) de matières solides de résine dans la composition de résine.

3. Composition de résine selon la revendication 1 ou 2, comprenant en outre une charge (C).

4. Composition de résine selon la revendication 1, dans laquelle la charge (C) comprend de la silice.

5. Composition de résine selon l'une quelconque des revendications 1 à 4, comprenant en outre un ou deux ou plusieurs choisis parmi le groupe se composant d'une résine époxy autre que la résine époxy (B) représentée par la formule générale (1), d'un composé maléimide, d'une résine phénolique, d'une résine oxétane, d'un composé benzoxazine, et d'un composé possédant un groupe insaturé polymérisable.

6. Composition de résine selon la revendication 3, 4 ou 5, dans laquelle une teneur en charge (C) va de 50 à 1600 parties en masse en fonction d'une quantité totale (100 parties en masse) de matières solides de résine dans la composition de résine.

7. Préimprégné comprenant :
un matériau de base; et la composition de résine selon l'une quelconque des revendications 1 à 6 avec laquelle le matériau de base est imprégné ou revêtu.

8. Stratifié revêtu d'une feuille métallique comprenant l'un parmi le préimprégné selon la revendication 7 ou deux ou plusieurs préimprégnés selon la revendication 7 stratifiés ; et une feuille métallique moulée en stratifié sur une surface ou les deux surfaces du préimprégné.

9. Feuille de résine comprenant un matériau de base en feuille ; et la composition de résine selon l'une quelconque des revendications 1 à 6 avec laquelle une surface ou les deux surfaces du matériau de base en feuille sont revêtues et qui est séchée.

10. Carte de circuit imprimée comprenant une couche isolante comprenant la composition de résine selon l'une quelconque des revendications 1 à 6 ; et une couche conductrice formée sur une surface ou les deux surfaces de la couche isolante.
